# FASCICULE DE BREVET EUROPEEN

(11) **EP 1 942 577 B1**
(45) Date de publication et mention de la délivrance du brevet: **06.01.2010**
(21) Numéro de dépôt: 07120327.7
(22) Date de dépôt: 09.11.2007
(51) Int. Cl.: H03K 19/00, H03K 17/687, H03K 17/16

(54) **Circuit integre avec mode de veille minimisant la consommation de courant**
Integrierter Schaltkreis mit im Ruhemodus reduziertem Stromverbrauch
Integrated circuit with minimised power consumption in stand-by state

(30) Priorité: 14.11.2006 FR 0609937
(43) Date de publication de la demande: 09.07.2008
(73) Titulaire: Commissariat A L'Energie Atomique - CEA, 75015 Paris (FR)
(72) Inventeur: VALENTIAN, Alexandre, 38120, SAINT-EGREVE (FR)
(74) Mandataire: Guérin, Michel

(56) Documents cités:
- US-A1- 2002 149 036
- US-A1- 2006 006 929
- US-A1- 2006 091 936
- US-B1- 6 940 307

## Description

L'invention concerne les circuits intégrés électroniques capables de fonctionner soit en mode actif soit en mode de veille et d'avoir, en mode de veille, une très faible consommation de courant.

Ces circuits sont nécessaires notamment dans les applications où l'alimentation est fournie par une batterie ou une pile (téléphones portables, appareils photographiques, ordinateurs portables, etc.), afin de ne pas consommer inutilement l'énergie de la source d'alimentation.

Dans ces applications, on réalise en général les circuits en technologie CMOS (métal oxyde semiconducteur complémentaire), permettant une consommation plus faible que d'autres technologies.

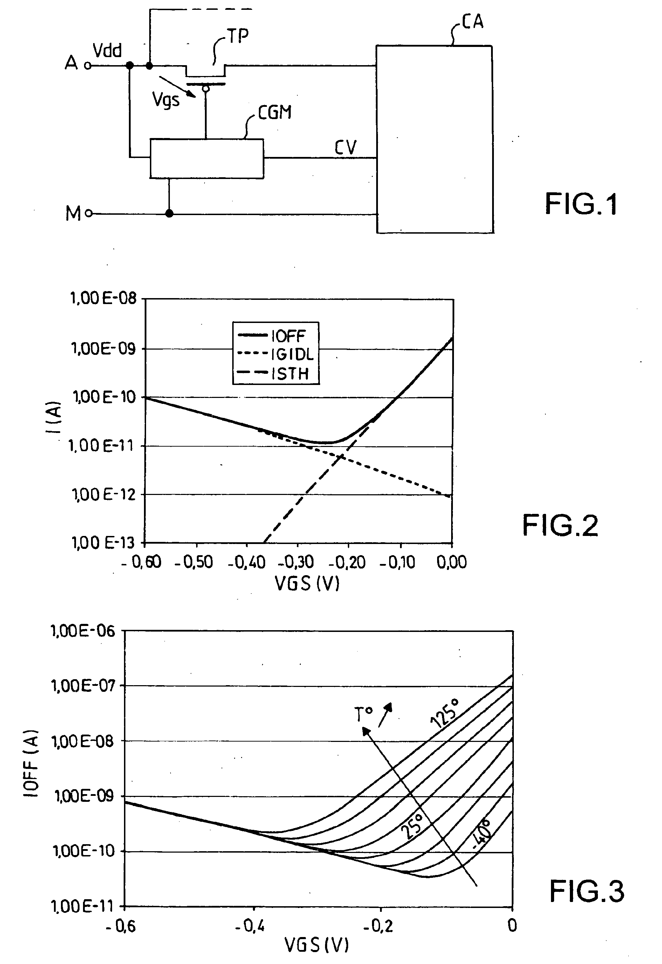

Pour passer d'un mode actif à une mode de veille, on prévoit en général dans le circuit intégré, comme on le voit sur la figure 1, un transistor de puissance TP interposé en série entre l'une des bornes d'alimentation A ou M du circuit intégré et la partie active du circuit (CA) ; ce transistor est contrôlé par un circuit CGM de gestion de mode qui établit sur la grille du transistor une tension ou une autre selon que le circuit intégré est en mode actif ou en veille ; la fonction de ce transistor de puissance est double :
- en mode actif : il est rendu fortement conducteur et laisse passer tout le courant nécessaire au circuit actif, avec une chute de tension minimale donc sans consommation de puissance inutile ;
- en mode de veille : il est bloqué pour interrompre le courant de la source d'alimentation vers le reste du circuit intégré.

Le transistor de puissance doit donc répondre à plusieurs contraintes : courant suffisamment élevé dans l'état passant ; très faible chute de tension dans l'état passant ; très faibles courants de fuite dans l'état bloqué ; et enfin, si possible, des dimensions aussi réduites que possible pour réduire l'encombrement sur le silicium du circuit intégré.

On a déjà proposé dans l'art antérieur divers types de transistors de puissance tentant de répondre à cet ensemble de contraintes. On en trouvera des exemples notamment dans les documents publiés suivants :
S. Mutoh et al., "1-V Power Supply High Speed Digital Circuit Technology with Multithreshold-voltage CMOS", IEEE Journal of Solid State Circuits, vol. 30, pp 847-854, Aug. 1995.
T. Inukai et al., "Boosted Gate OS (BGMOS): Device/Circuit Cooperation Scheme to Achieve Leakage-Free Giga-Scale Integration", Custom Integrated Circuits Conference, pp. 409-412, May 2000.
H. Kawaguchi et al., "A super Cut-Off CMOS (SCCMOS) Scheme for 0,5 V Supply Voltage with Picoampere Stand-by Current", IEEE Journal of Solid State Circuits, vol. 35 N°10, pp 1498-1501, Oct 2000.

Dans ce dernier document, on utilise un transistor de puissance à tension de seuil basse fournissant un courant élevé dans l'état passant et dont on réduit le courant de fuite en sur-polarisant la grille en inverse en mode de veille ; par sur-polarisation inverse on entend une polarisation à une tension plus basse que la borne la plus négative de la tension d'alimentation, pour un transistor NMOS, ou plus haute que la tension d'alimentation la plus positive pour un transistor PMOS.

Le transistor de puissance du document cité en dernier est celui qui présente le meilleur compromis entre la surface occupée (pour un courant donné dans l'état passant), et le courant de fuite dans l'état bloqué.

On constate que le courant de fuite, qui est d'abord dû au courant de conduction I_{STH} entre source et drain (courant sous le seuil) diminue exponentiellement lorsqu'on polarise plus négativement la grille (pour un NMOS) ; il peut devenir extrêmement faible. Cependant, un deuxième phénomène doit être pris en compte ; il s'agit de l'apparition d'un courant de drain induit par la grille : en polarisant la grille en inverse, il apparaît un courant de fuite non plus entre drain et source mais entre drain et substrat du circuit intégré. Typiquement, dans la configuration de la figure 1 où le transistor de puissance TP est un transistor PMOS dont la source est reliée à la borne d'alimentation la plus positive A, la grille est portée à un potentiel encore plus positif en mode de veille, alors que le drain va rester pratiquement au potentiel de la borne M qui est le potentiel bas de l'alimentation. Les paires électrons-trous générées naturellement dans le drain subissent l'influence du champ électrique important qui existe alors entre grille et drain là où la grille surplombe le bord du drain ; le champ électrique généré entre grille et drain tend à abaisser localement la barrière de potentiel entre drain et substrat ; des électrons peuvent franchir cette barrière et passer vers le substrat, créant un courant de fuite substrat/drain malgré l'interruption du courant source/drain. Ce courant I_{GIDL} ou courant de drain induit par la grille augmente significativement lorsque la tension entre grille et drain augmente ; l'augmentation est sensiblement exponentielle.

La sur-polarisation inverse de grille engendre donc un courant de fuite additionnel pour la batterie d'alimentation du circuit, et ce courant croît fortement avec le niveau de sur-polarisation. Cela veut dire que si on augmente trop la tension grille-source en négatif (NMOS) ou en positif (PMOS), la très forte réduction du courant de fuite entre source et drain ne sert plus à rien car une autre source de fuites devient prédominante.

La courbe de la figure 2 représente un exemple de tracé des deux courbes de courant de fuite variant en sens inverse. L'échelle est logarithmique pour les courants en ordonnée et linéaire pour les tensions grille-source en abscisse. En traits tiretés le courant de conduction entre drain et source I_{STH} ; en traits pointillés : le courant de drain induit par la grille I_{GIDL} (traits pointillés) ; en traits pleins, la somme de ces deux courants qui est le courant total de fuite I_{OFF}. La courbe est tracée pour un transistor NMOS, la tension grille-source ayant des valeurs négatives (grille plus négative que la source) ; pour un transistor PMOS, la courbe serait identique mais graduée en tension positive (grille plus positive que la source).

On voit que le courant total de fuite présente un minimum pour une certaine valeur de tension grille-source, et il serait optimal de se placer à cette valeur en mode de veille.

Malheureusement, ce point optimal n'est pas facile à trouver dans la réalité en raison de la dispersion des paramètres technologiques, au sein d'une fabrication ou entre plusieurs lots fabriqués. Il dépend aussi de la valeur de la tension d'alimentation du circuit et de la température. La figure 3 illustre un exemple de variation en fonction de la température ; les courbes de courant de fuite I_{OFF} tracées sur cette figure, pour des températures respectives de -40°c, -25°C, 0°C, +25°C, °50°C, +100°C, +125°C, montrent que le courant peut varier de plus d'une décade et demie entre -40°c et + 125°C lorsqu'on se place au minimum de la courbe à +25°C, et encore plus si on est à droite du minimum.

Dans l'art antérieur, on a proposé de comparer les courants de fuite de deux transistors semblables au transistor de puissance mais plus petits et polarisés à deux tensions de grille différentes mais telles que leurs courants de fuite soient égaux, et de polariser alors le transistor de puissance à une valeur intermédiaire entre les deux tensions différentes, cette valeur représentant à peu près l'optimum.

Ceci est décrit dans la publication de brevet WO 2006/017082 A2, et la publication US 2006/0006929.

Ce document décrit aussi une autre méthode utilisant un seul transistor semblable au transistor de puissance ; on mesure le courant de fuite par le temps de décharge d'une capacité préchargée à la tension d'alimentation ; on recherche la polarisation qui maximise le temps de décharge. Mais le temps de décharge risque de varier dans une très large gamme de valeurs, et, de plus, le transistor témoin ne sera pas dans les mêmes conditions de tension d'alimentation au cours de la décharge que le transistor de puissance, ce qui fausse le principe de la mesure.

Il existe aussi une troisième méthode, décrite dans l'article de C. Neau et al., "Optimal Body Bias Selection for Leakage Improvement and Process Compensation Over Different Technology Generations", ISLPED, 2003. Cette méthode est applicable à certains types de transistors seulement ; elle consiste à polariser en inverse le substrat semiconducteur sur lequel est formé le transistor de puissance. Mais cette méthode nécessite de trouver un compromis entre deux courants opposés dont la variation est opposée en fonction de la polarisation, qui sont respectivement le courant tunnel de bande à bande (I_{BTBT}) et le courant de conduction sous le seuil I_{SHT}.

La publication US 2006/0091936 utilise aussi une polarisation inverse de substrat.

Un objectif de l'invention est de réaliser une polarisation automatique qui minimise le courant de fuite d'une manière aussi indépendante que possible des variations et dispersions technologiques, des variations de température, et des variations de tension d'alimentation.

Pour cela, en examinant les courbes de la figure 1, on considère que l'on est pratiquement à la tension de grille négative (NMOS) optimale si le courant de conduction sous le seuil I_{STH} (courant drain-source) est égal au courant de drain induit par la grille I_{GIDL}. Ce n'est pas tout-à-fait exact car les pentes de variation de courant en fonction de la tension grille source ne sont pas les mêmes mais c'est une très bonne approximation.

On s'arrange donc pour comparer un courant de type I_{STH} et un courant de type I_{GIDL}, en vue de trouver le point où ils sont égaux. Mais comme il n'est pas facile de produire un courant I_{STH} seul ne comportant pas une composante I_{GIDL}, on va plutôt comparer un courant I_{SHT}+I_{GIDL} à un courant 2.I_{GDIL}, ce qui revient au même lorsqu'il y a égalité.

On produit donc dans le circuit intégré, en vue de les comparer, deux courants distincts, l'un de type I_{STH}+I_{GDIL} dans un premier transistor de même constitution technologique que le transistor de puissance (pour avoir la même variation de courant de fuite en fonction de la tension grille-source), et l'autre de type 2.I_{GIDL} dans un deuxième transistor, identique au premier, monté avec sa source et son drain réunis de manière que le courant I_{STH} s'annule et que le courant I_{GIDL} soit doublé.

C'est pourquoi on propose selon l'invention un procédé de contrôle du courant de fuite d'un transistor de puissance inséré en série entre une borne d'alimentation et un circuit actif, dans lequel le transistor de puissance est fortement bloqué en mode de veille par une sur-polarisation inverse de grille, caractérisé en ce qu'il comprend les opérations suivantes :
- polariser un premier transistor de référence, et un second transistor de référence identique au premier et de caractéristiques technologiques représentatives du transistor de puissance, avec la même tension de sur-polarisation inverse de grille que le transistor de puissance, le premier transistor ayant sa source reliée à la borne d'alimentation, et le second transistor de référence ayant sa source reliée à son drain,
- comparer les courants parcourant les deux transistors de référence dans un comparateur de courant,
- modifier la tension de sur-polarisation inverse de grille dans un sens tendant à réduire la différence entre les courants comparés.

L'invention propose également un circuit intégré comportant un transistor de puissance en série entre une borne d'alimentation et un circuit actif susceptible de fonctionner en mode actif ou en mode de veille, et un circuit de polarisation de grille pour appliquer à la grille du transistor de puissance un potentiel de polarisation directe en mode actif, pour rendre le transistor conducteur, et un potentiel de sur-polarisation inverse en mode de veille, pour bloquer fortement le transistor, caractérisé en ce que le circuit de polarisation comporte
- un premier transistor de référence et un second transistor de référence, identiques entre eux et de caractéristiques technologiques représentatives du transistor de puissance, recevant sur leur grille en mode de veille la même tension de polarisation inverse que le transistor de puissance, le premier transistor de référence ayant sa source reliée au même potentiel que la source du transistor de puissance, et le second transistor de référence ayant sa source et son drain réunis,
- un circuit de comparaison des courants de fuite des deux transistors, ce circuit de comparaison ayant une entrée reliée au drain du premier transistor de référence et une entrée reliée au drain du second transistor de référence,
- et un circuit d'ajustement de la tension de sur-polarisation inverse, recevant la sortie du circuit de comparaison et réagissant à cette sortie pour augmenter ou diminuer la tension de sur-polarisation inverse selon le sens du résultat de la comparaison effectuée par le circuit de comparaison de façon à réduire la différence entre les courants de fuite des premier et second transistors.

Le circuit de comparaison de courants émet de préférence une impulsion brève sur une première sortie si le courant sur une première entrée est plus élevé que sur la deuxième, et une impulsion brève sur une deuxième sortie si le courant sur la deuxième entrée est plus élevé que sur la première.

Le circuit d'ajustement de la tension de sur-polarisation inverse de grille comporte de préférence deux entrées reliées aux sorties du comparateur de courant, et un ensemble de deux transistors montés en série en push-pull analogique, les grilles de ces transistors étant commandées l'une à partir d'une des entrées l'autre à partir de l'autre entrée, la sortie du circuit d'ajustement étant constituée par les drains réunis des deux transistors.

On comprendra que la première entrée du circuit de comparaison reçoit un courant de drain du premier transistor de référence, qui est un courant de fuite global de type I_{STH}+ I_{GIDL}, alors que la deuxième entrée reçoit un courant de fuite qui ne comporte pas de composante I_{STH} parce que la source et le drain du deuxième transistor de référence sont court-circuités, et qui comporte une composante de courant de drain induit par la grille qui est le double de la composante I_{GIDL} du premier transistor parce que la source contribue autant que le drain à ce courant et parce que le transistor est de même taille que le premier.

D'autres caractéristiques et avantages de l'invention apparaîtront à la lecture de la description détaillée qui suit et qui est faite en référence aux dessins annexés dans lesquels :
- la figure 1 représente la configuration d'un circuit ayant un mode actif et un mode de veille, avec un transistor de puissance en série pour contrôler le passage d'un mode à l'autre ;
- la figure 2, déjà décrite, représente une courbe de variation de courants de fuite en fonction de la tension de grille, en polarisation inverse ;
- la figure 3, déjà décrite, représente la variation des courants de fuite globaux en fonction de la température ;
- la figure 4 représente un circuit selon la présente invention ;
- la figure 5 représente un comparateur de courants ;
- la figure 6 représente un circuit fournissant un signal de précharge ;
- la figure 7 représente un circuit d'ajustement de la tension Vg.

La partie active principale CA du circuit intégré de la figure 1 possède une fonctionalité quelconque (par exemple de téléphonie pour un téléphone, de prise de vue pour un appareil photographique, etc.). Cette fonctionalité est pourvue d'un mode actif et d'un mode de veille. Le mode de veille peut typiquement s'activer tout seul après un temps de non utilisation déterminé, ou encore il peut s'activer sur commande d'un utilisateur.

Il y a deux bornes d'alimentation A et M qui alimentent directement les circuits qui doivent rester alimentés en permanence et qui alimentent indirectement le circuit actif CA, à travers un transistor de puissance TP en série entre une des bornes d'alimentation et le circuit CA.

Dans le mode de veille, l'alimentation du circuit actif CA est coupée par le transistor. Seuls restent alimentés quelques circuits à faible consommation, par exemple un circuit (non représenté) pour détecter une demande de retour au mode actif et un circuit de gestion de mode CGM qui commande la grille du transistor de puissance.

Dans ce qui suit on considère que la borne d'alimentation A est une borne d'alimentation positive à une tension Vdd, la borne M est une borne d'alimentation qu'on considérera comme une borne de masse (potentiel zéro), donc plus négative que la borne A ; le transistor de puissance TP est un transistor PMOS et sa source est reliée à la borne A. On doit comprendre cependant que le transistor TP pourrait être un transistor NMOS inséré sur l'autre conducteur d'alimentation, c'est-à-dire entre la borne M et le circuit actif, la source du transistor étant reliée à la borne M.

Le drain du transistor TP est relié au circuit actif CA et ce dernier ne reçoit un courant d'alimentation que si le transistor TP est conducteur.

Le circuit de gestion de mode CGM a donc deux états de fonctionnement possible : dans un premier état correspondant au mode actif, il établit une tension nulle (tension de la borne M) sur la grille du transistor TP, pour rendre le transistor franchement conducteur avec une très faible chute de tension ; dans un deuxième état correspondant au mode de veille, il établit une tension de blocage sur la grille du transistor afin que le transistor ne laisse plus passer de courant. Le circuit de gestion de mode CGM est donc essentiellement un circuit de polarisation de la grille du transistor TP.

Si le transistor de puissance TP a une tension de seuil assez élevée (en valeur absolue), il suffit que la tension appliquée à la grille en mode de veille soit égale à la tension sur la borne A pour bloquer fortement le passage du courant, et dans ce cas le circuit de gestion de mode CGM peut être extrêmement simple à réaliser puisqu'il suffit de porter la grille soit au potentiel de la masse M soit au potentiel de la borne A. Mais l'inconvénient est qu'un transistor de puissance réalisé dans une technologie qui lui donne une tension de seuil élevé doit avoir une taille assez grande, faute de quoi la chute de tension en direct (pour un courant d'alimentation donné) serait trop élevée ; cette taille assez grande est préjudiciable en termes de coûts de fabrication.

Si le transistor de puissance TP a une tension de seuil plus basse (obtenue par un choix de dopage approprié du canal), autorisant une taille de transistor plus faible, alors le blocage risque d'être imparfait si on se contente d'appliquer sur la grille le même potentiel que sur la source.

C'est pourquoi, dans ce cas, le circuit CGM est conçu pour appliquer à la grille une tension de sur-polarisation inverse encore plus positive que la tension Vdd qui est présente sur la borne A ; le courant de conduction sous le seuil (I_{STH}) se réduit alors conformément à la figure 2 lorsque la tension grille-source augmente en valeur absolue (signe des valeurs de Vgs de la figure 2 à inverser puisqu'on parle ici d'un transistor PMOS alors que la courbe de la figure 2 correspond à un transistor NMOS).

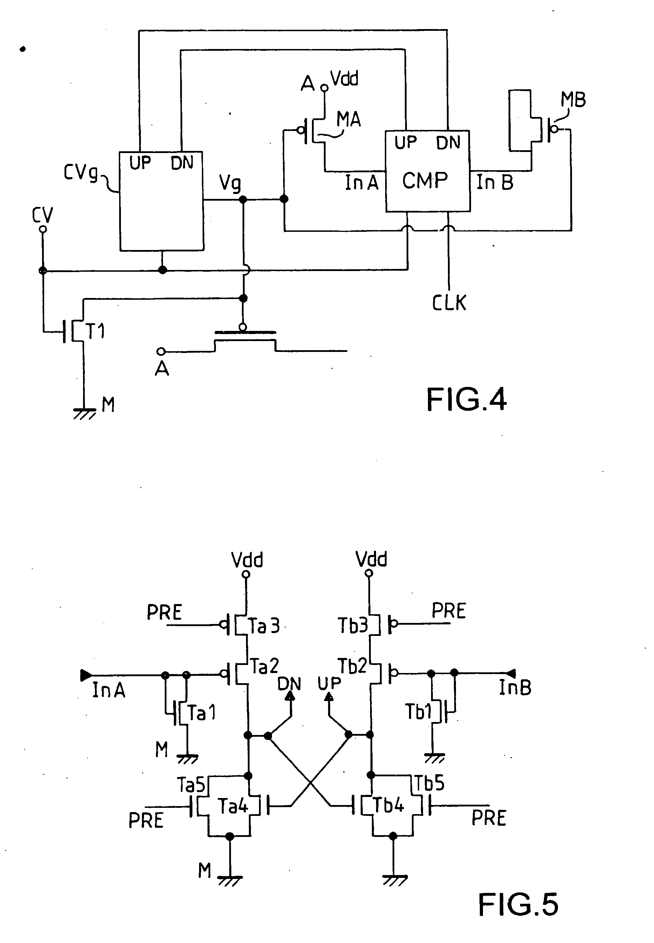

La structure générale du circuit de gestion de mode selon l'invention est représentée sur la figure 4. Le circuit a une entrée CV pour recevoir un signal logique de commande de mode. Si le mode est actif, la commande CV est au niveau logique haut (1) ; elle rend conducteur un transistor T1 qui met la grille du transistor TP à la masse, rendant conducteur ce dernier (PMOS). Si le mode est le mode de veille, la commande CV est au niveau logique bas (0), bloquant le transistor T1 et activant un circuit de sur-polarisation inverse de grille qui applique à la grille de TP un potentiel Vg supérieur au potentiel Vdd de la borne A, à la fois assez haut pour bien bloquer le courant source-drain I_{SHT} dans ce transistor mais suffisamment bas pour ne pas engendrer un courant I_{GIDL} induit par la grille trop élevé.

Ce circuit de surpolarisation comprend principalement :
- un premier transistor de référence, MA, ayant des caractéristiques technologiques représentatives de celles du transistor de puissance mais de plus petite taille pour limiter la consommation de courant ; par caractéristiques technologiques représentatives, on entend essentiellement le fait qu'il est réalisé avec les mêmes étapes et paramètres technologiques, en particulier la même tension de seuil (donc le même niveau de dopage de canal) ;
- un second transistor de référence, MB, identique au transistor MA ;
- un circuit CVg d'ajustement de la tension de grille, qui élabore un potentiel de grille Vg qui est appliqué aux grilles des trois transistors TP, MA, MB ; ce circuit possède des entrées de commande UP et DN destinées à agir sur la valeur de Vg ;
- un circuit de comparaison de courants CMP, qui a deux entrées InA et InB reliées respectivement au drain du transistor MA et au drain du transistor MB, et qui a des sorties reliées aux entrées UP et DN du circuit CVg ;
- et une entrée d'horloge CLK recevant un signal logique d'horloge a relativement basse fréquence, par exemple 1 MHz.

Le transistor MA a sa source reliée, comme celle du transistor TP, à la borne d'alimentation haute A, donc à la tension d'alimentation Vdd.

Si on s'arrange pour que le potentiel sur l'entrée lnA soit proche de zéro, alors les courants qui parcourent le transistor MA sont proportionnels aux courants de fuite du transistor de puissance TP, avec un rapport de proportionalité qui est celui des largeurs de grille de ces deux transistors ; en effet, le transistor MA et le transistor TP sont de même constitution technologique et ont sensiblement les mêmes tensions sur leurs électrodes respectives ; le courant de fuite I_{OFFA} dans le transistor MA, appliqué à l'entrée InA, comporte une composante I_{STHA} de courant de fuite source-drain et une composante I_{GIDLA} de courant de drain induit par la grille, proportionnelles aux composantes I_{STH} et I_{GIDL} du transistor TP.

Le transistor MB a sa source reliée à son drain et à l'entrée InB du comparateur de courants ; la grille reçoit la même tension Vg que les transistors TP et MA. Si on fait en sorte que le potentiel du drain de MB soit proche de zéro, alors le courant parcourant ce transistor et appliqué à l'entrée InB est un courant qui comporte :
- une composante I_{GIDLB} de courant de drain induit par la grille, proportionnelle à la composante I_{GIDL} du transistor TP ; mais aussi une composante identique I_{GIDLB} de courant de source induit par la grille, car l'effet de la grille sur la source est le même que l'effet sur le drain, la source étant semblable au drain, avec un même recouvrement de la grille au-dessus de la source et du drain ; au total une composante 2I_{GIDL} ;
- mais pas de composante de courant source-drain I_{STHB}, tout simplement parce que la source et le drain sont au même potentiel et qu'il ne peut y avoir de courant circulant entre eux.

Il en résulte que le comparateur de courants CMP va comparer deux courants qui sont respectivement I_{STHA} + I_{GIDLA} et 2-I_{GIDLB}.

Comme les transistors MA et MB sont identiques, cela revient à comparer I_{STHA} + I_{GIDLA} et 2.I_{GIDLA}, ou encore I_{STHA} et I_{GIDLA}, ou encore I_{STH} et I_{GIDL}. En effectuant une régulation tendant à ajuster Vg à une valeur qui maintient l'égalité entre les courants sur les entrées InA et InB, on tend donc à maintenir la polarisation du transistor TP à une valeur où ses deux courants de fuite I_{STH} et I_{GIDL} sont égaux, c'est-à-dire une valeur proche de l'optimum du point de vue de la minimisation des fuites en mode de veille, comme on l'a expliqué à propos de la figure 2.

Le comparateur de courant comporte deux sorties UP et DN qui fournissent des signaux complémentaires indiquant celui des courants d'entrée en InA et InB qui est le plus élevé ; ces signaux servent à commander le circuit CVg d'ajustement de la tension Vg.

Dans l'exemple préférentiel de réalisation, les signaux UP et DN sont de brèves impulsions logiques complémentaires, produites à la fréquence d'horloge CLK, et leur effet est d'augmenter légèrement ou de diminuer légèrement la tension Vg à chaque impulsion d'horloge, de sorte que la tension Vg se stabilise à une valeur moyenne où les courants I_{STH} et I_{GIDL} sont égaux. Cette valeur moyenne optimale est alors maintenue quelle que soit la valeur de la tension d'alimentation ou la température puisque la régulation se fait en permanence lorsque le système est en mode de veille.

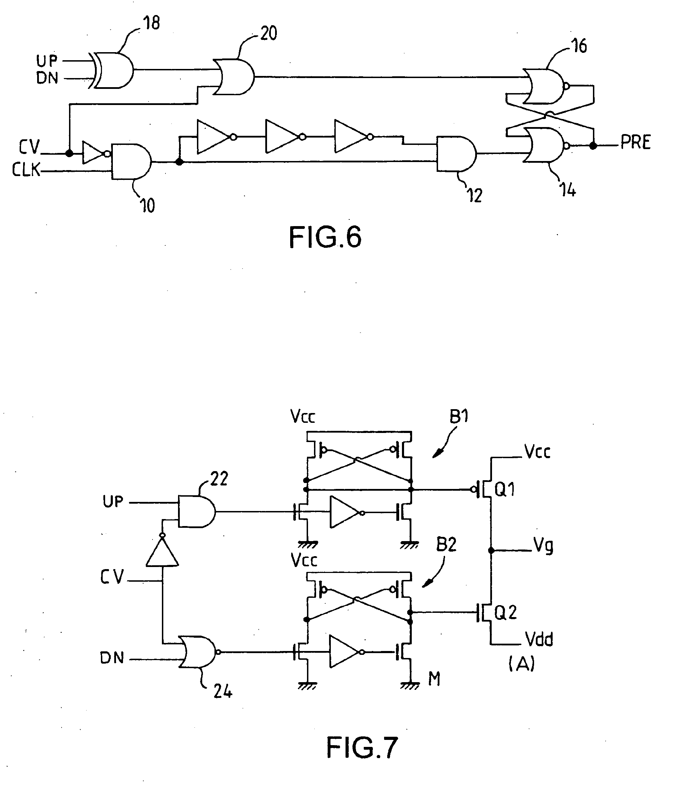

Le comparateur de courants utilisé peut être conforme à celui qui est représenté à la figure 5. Il est conçu pour effectuer des comparaisons instantanées à une fréquence assez basse (1 MHz par exemple) pour minimiser la consommation, sachant qu'entre deux comparaisons la tension Vg ne va guère bouger. Le circuit de comparaison délivre une brève impulsion sur la sortie UP lorsque le courant sur l'entrée InA est supérieur au courant sur l'entrée InB, et réciproquement il délivre une brève impulsion sur la sortie DN dans le cas contraire. L'impulsion sur la sortie UP est utilisée dans le circuit de la figure 7 pour accroître légèrement la tension Vg ; l'impulsion sur la sortie DN est utilisée pour abaisser légèrement la tension Vg. La tension Vg se stabilise autour d'une valeur moyenne optimale.

Le comparateur de la figure 5 fonctionne de la manière suivante : l'entrée InA qui reçoit le courant de drain du transistor MA est reliée à la grille et au drain d'un transistor Ta1 NMOS monté en diode et ayant sa source reliée à la masse M ; le transistor Ta1 sert de convertisseur courant-tension ; du fait que le courant de fuite qui va parcourir ce transistor est très faible, la tension sur l'entrée lnA variera proportionnellement au courant mais restera toujours très proche de zéro, ce qui est souhaitable, on le rappelle, pour que le transistor MA soit autant que possible dans les mêmes conditions que le transistor TP ; l'entrée InA est reliée par ailleurs à la tension de grille d'un transistor PMOS Ta2.

D'une manière identique, l'entrée InB est reliée à un transistor NMOS Tb1 convertisseur courant-tension, monté en diode entre InB et la masse M ; l'entrée InB est reliée aussi à la grille d'un transistor PMOS Tb2.

Les transistors Ta2 et Tb2 font partie d'une paire de branches différentielles comportant chacune trois transistors en série Ta3, Ta2, et Ta4 (première branche) ou Tb3, Tb2, Tb4 (deuxième branche). Les transistors Ta3 et Tb3 sont des PMOS ayant leur source à la tension d'alimentation Vdd et leur grille commandée par un signal de précharge PRE. Le signal de précharge PRE, normalement au niveau 1, passe à zéro périodiquement (période de l'horloge CLK) pour déclencher une étape de comparaison.

Le transistor Ta2 est un PMOS qui a sa source reliée au drain de Ta3 et son drain relié au drain du transistor NMOS Ta4. La source du transistor Ta4 est à la masse. Les drains réunis de Ta2 et Ta4 forment la sortie DN du comparateur de courants. Le montage est le même pour la deuxième branche, les transistors Tb3, Tb2, Tb4 étant montés comme les transistors Ta3, Ta2, Ta4. Les drains réunis des transistors Tb2 et Tb4 forment la sortie complémentaire DN du comparateur de courants.

La grille du transistor Ta4 est reliée à la sortie UP et la grille de Tb4 est reliée à la sortie DN, ce croisement entre les branches différentielles formant une bascule instable tendant à faire passer très rapidement la sortie UP et la sortie DN dans des états logiques stables complémentaires si un léger déséquilibre de courants apparaît dans les branches différentielles.

Enfin, un transistor NMOS Ta5 en parallèle avec le transistor Ta 4, et un transistor NMOS Tb5 en parallèle avec le transistor Tb4 sont commandés par le signal de précharge PRE pour maintenir les sorties UP et DN à zéro en dehors de la phase de comparaison définie par le signal PRE.

Lorsque le signal PRE passe brièvement à zéro pour une phase de comparaison, les transistors Ta5 et Tb5 bloqués n'interviennent plus ; Ta3 et Tb3 deviennent conducteurs ; les potentiels nuls de UP et DN tendent à monter ; les courants dans les branches différentielles dépendent du niveau de potentiel des entrées InA et InB, c'est-à-dire des valeurs de courant de fuite provenant des transistors MA et MB ; si le courant dans l'entrée InA est plus élevé que le courant dans l'entrée lnB, le courant dans Ta2 est plus faible que le courant dans Tb2 ; le potentiel de la sortie DN tend à monnter moins vite que le potentiel de la sortie UP ; la montée plus rapide du potentiel UP renforce la conduction de Ta4 ; la montée moins rapide de DN limite la conduction du transistor Tb4, confirmant le sens du déséquilibre initial ; le système bascule très rapidement vers un niveau logique haut de UP et un niveau logique bas de DN ; le basculement inverse se produirait si le courant dans l'entrée InA était plus faible que le courant dans l'entrée InB.

On notera que tous les transistors de la branche Ta3, Ta2, Ta4 sont alors conducteurs si c'est la sortie UP qui est passée au niveau haut ; cela consomme du courant et il faut donc que l'impulsion PRE soit très brève pour à nouveau interrompre cette consommation par le transistor Ta3 (ou Tb3). Il est d'ailleurs souhaitable d'asservir la durée de l'impulsion PRE sur le basculement du signal UP ou DN pour minimiser cette consommation.

A la fin de l'impulsion de précharge PRE les sorties UP et DN reviennent à zéro. Les signaux produits par le comparateur de courant à la périodicité de l'impulsion de précharge (période de CLK) sont donc une impulsion brève sur l'une des deux sorties UP et DN, l'autre restant à zéro.

La figure 6 représente un circuit faisant partie du comparateur de courants, circuit qui permet d'élaborer périodiquement une impulsion de précharge PRE très brève ; le circuit utilise les signaux de sortie UP et DN du comparateur eux-mêmes pour interrompre l'impulsion de précharge.

Ce circuit reçoit l'horloge CLK et le signal de commande de mode CV. Pour le mode actif (CV=1) le signal PRE reste en permanence à 1 et il n'y jamais d'impulsion de précharge. UP et DN restent à zéro et le circuit de la figure 7 qui élabore la tension Vg laisse celle-ci flottante, de sorte que la valeur de la tension Vg, dictée par le transistor T1 de la figure 4, est nulle.

Pour le mode de veille (CV=0), la porte ET 10 transmet l'horloge CLK, et son complément retardé par des inverseurs en série, aux entrées d'une porte ET 12 de manière à produire une impulsion de déclenchement très brève sur le front montant du signal d'horloge ; cette impulsion, appliquée à une première entrée d'une bascule RS constituée par deux portes NI 14 et 16 bouclées l'une sur l'autre, fait passer à zéro le signal de sortie PRE de cette bascule, initialement à 1. Le processus de comparaison est alors déclenché dans le circuit comparateur de courants de la figure 6 et va générer un passage au niveau haut de la sortie UP ou la sortie DN.

Une porte OU-Exclusif 18 reçoit les signaux UP et DN et fournit un signal en général nul (car UP et DN sont le plus souvent à 0), qui passe à 1 à l'apparition du niveau haut sur la sortie UP ou DN du comparateur.

Dès que UP ou DN passe à 1, l'autre restant à zéro, la sortie de la porte OU-Exclusif 18 passe à 1 ; cette sortie est reliée à une entrée d'une porte OU 20 qui a CV=0 sur son autre entrée ; la sortie de la porte OU 20 passe de zéro à 1 ; ce passage à 1 fait rebasculer la bascule 14, 16 dans l'autre sens, ce qui remet le signal PRE à 1.

Le signal de précharge PRE reste à 1 jusqu'au front de montée suivant de l'horloge, ou reste à 1 si le circuit passe en mode actif (CV=1, blocage de l'horloge, maintien à zéro de la sortie de la porte 12 et à 1 de la sortie de la porte 20 donc immobilisation de la bascule RS).

La figure 7 représente le circuit CVg qui ajuste la tension Vg en mode de veille à partir des impulsions apparaissant sur les sorties UP et DN du comparateur de courants, impulsions qui sont transmises sur des entrées correspondantes UP et DN du circuit CVg.

Le circuit CVg a une entrée CV qui l'inhibe lorsque CV=1 c'est-à-dire en mode actif. Une porte ET 22 reçoit le complément de CV et l'entrée UP. Sa sortie fournit une brève impulsion de niveau logique 1 en mode de veille lorsque la comparaison de courant fournit une brève impulsion de niveau 1 sur l'entrée UP. Pour l'entrée DN, une porte NI 24 reçoit CV et l'entrée DN ; la sortie de la porte 24, normalement à 1, fournit une brève impulsion de niveau logique 0 en mode de veille lorsque la comparaison de courant fournit une brève impulsion de niveau 1 sur l'entrée DN.

Deux transistors Q1 (PMOS) et Q2 (NMOS) sont montés en série en push-pull analogique entre deux tensions continues Vdd et Vcc (Vcc supérieur à Vdd, Q1 connecté à Vcc, Q2 connecté à Vdd). Le point de jonction des drains de ces transistors fournit la tension de polarisation désirée Vg. Les drains sont en haute impédance en général car la grille de Q1 est normalement portée au potentiel le plus haut Vcc et la grille de Q2 est portée au potentiel de la masse (plus bas que Vdd).

S'il apparaît une impulsion de niveau 1 à la sortie de la porte ET 22, une bascule B1 commandée par cette sortie fait passer le potentiel sur la grille de Q1 à zéro. Q1 devient conducteur le temps de cette impulsion et tend à faire monter le potentiel Vg. Il n'y a pas d'action sur le transistor Q2 qui reste bloqué. A la fin de l'impulsion, le potentiel Vg a un peu monté.

Inversement, s'il apparaît une impulsion de niveau 1 à la sortie de la porte NI 24, une bascule B2 commandée par cette sortie fait passer le potentiel sur la grille de Q2 à Vcc (plus haut que Vdd, l'écart entre Vcc et Vdd étant supérieur à la tension de seuil de Q2). Q2 devient conducteur le temps de cette impulsion et tend à faire descendre le potentiel Vg. Il n'y a pas d'action sur le transistor Q1 qui reste bloqué. Quand l'impulsion s'interrompt, le potentiel Vg a un peu baissé.

Ce circuit de sur-polarisation inverse de grille doit utiliser non seulement le potentiel de masse (connexion à la borne M) et le potentiel Vdd (connexion à la borne A) mais aussi un potentiel Vcc plus élevé que celui de la borne A. Le potentiel Vcc plus élevé peut être obtenu soit directement si pour une raison ou une autre il est présent dans le circuit intégré, par exemple sur une borne de connexion extérieure, soit indirectement, par exemple par l'intermédiaire d'une pompe de charge. La production d'une tension plus élevée que la tension d'alimentation générale au moyen d'une pompe de charge est classique. A titre d'exemple, la tension d'alimentation Vdd est de 1,2 volt, norme pour de petits appareils portables, et la tension Vcc plus élevée peut être de 2,5 volts.

Pour terminer, on peut noter que si le transistor de puissance TP est formé dans un caisson diffusé dans le substrat du circuit intégré, on peut agir sur la polarisation du caisson pour réduire encore les courants de fuite. En effet, si le caisson n'est pas au potentiel de la source du transistor (borne A) mais à un potentiel VBS supérieur à celui de la source (pour un transistor PMOS), alors les courants de fuite sont réduits. On peut prendre typiquement comme potentiel du caisson le potentiel Vcc plus élevé que le potentiel Vdd de la borne A. Une valeur de Vcc deux fois plus élevée que Vdd est particulièrement commode. Dans ce cas, on constate que l'optimum de la tension de grille Vg diminue en valeur absolue, et cette diminution est favorable pour éviter le vieillissement de l'oxyde de grille ; ce vieillissement est en effet d'autant plus important que la tension de grille est plus élevée en valeur absolue (phénomène dit de "stress du diélectrique de grille").

## Revendications

1. Procédé de contrôle du courant de fuite d'un transistor de puissance (TP) inséré en série entre une borne d'alimentation (A) et un circuit actif (CA), dans lequel le transistor de puissance est fortement bloqué en mode de veille par une sur-polarisation inverse de grille, **caractérisé en ce qu'**il comprend les opérations suivantes :
- polariser un premier transistor de référence (MA), et un second transistor de référence (MB) identique au premier et de caractéristiques technologiques représentatives du transistor de puissance, avec la même tension de sur-polarisation inverse de grille (Vg) que le transistor de puissance, le premier transistor ayant sa source reliée à la borne d'alimentation (A), et le second transistor de référence ayant sa source reliée à son drain,
- comparer les courants parcourant les deux transistors de référence (MA, MB) dans un comparateur de courant (CMP),
- modifier la tension de sur-polarisation inverse de grille (Vg) dans un sens tendant à réduire la différence entre les courants comparés.

2. Circuit intégré comportant un transistor de puissance (TP) en série entre une borne d'alimentation (A) et un circuit actif (CA) susceptible de fonctionner en mode actif ou en mode de veille, et un circuit de polarisation de grille (CGM) pour appliquer à la grille du transistor de puissance un potentiel de polarisation directe en mode actif pour rendre le transistor conducteur et un potentiel de sur-polarisation inverse Vg en mode de veille pour bloquer fortement le transistor, **caractérisé en ce que** le circuit de polarisation comporte
- un premier transistor de référence (MA) et un second transistor de référence (MB), identiques entre eux et de caractéristiques technologiques représentatives du tansistor de puissance (TP), recevant sur leur grille en mode de veille la même tension de polarisation inverse Vg que le transistor de puissance, le premier transistor de référence (MA) ayant sa source reliée au même potentiel que la source du transistor de puissance, et le second transistor de référence (MB) ayant sa source et son drain réunis,
- un circuit (CMP) de comparaison des courants de fuite des premier et second transistors, ce circuit de comparaison ayant une entrée (InA) reliée au drain du premier transistor de référence (MA) et une entrée (InB) reliée au drain du second transistor de référence (MB),
- et un circuit (CVg) d'ajustement de la tension de sur-polarisation inverse Vg, recevant la sortie du circuit de comparaison et réagissant à cette sortie pour augmenter ou diminuer la tension de sur-polarisation inverse Vg selon le sens du résultat de la comparaison effectuée par le circuit de comparaison de façon à réduire la différence entre les courants de fuite des premier et second transistors.

3. Circuit intégré selon la revendication 2, **caractérisé en ce que** le circuit de comparaison de courants comporte un circuit (Ta2, Ta3, Ta4, Tb2, Tb3, Tb4) produisant une impulsion brève sur une première sortie (UP) si le courant sur une première entrée est plus élevé que sur la deuxième, et une impulsion brève sur une deuxième sortie (DN) si le courant sur la deuxième entrée est plus élevé que sur la première.

4. Circuit intégré selon la revendication 3, **caractérisé en ce que** le circuit de comparaison de courants comporte deux branches différentielles (Ta3, Ta2, Ta4 ; Tb3, Tb2, Tb4) rétroagissant l'une sur l'autre pour produire un basculement rapide en cas de différence de courants sur les entrées, et un circuit de précharge établissant un signal de déclenchement d'une comparaison (PRE) dont le démarrage est commandé par un front d'horloge et dont l'arrêt est commandé par l'apparition d'une impulsion brève sur une des sorties du comparateur.

5. Circuit intégré selon l'une des revendications 2 à 4, **caractérisé en ce que** les entrées du circuit de comparaison de courants sont reliées chacune à un convertisseur courant-tension (Ta1, Tb1).

6. Circuit intégré selon la revendication 5, **caractérisé en ce que** le convertisseur de tension est un transistor monté en diode (Ta1, Tb1) entre l'entrée et une autre borne (M) d'alimentation.

7. Circuit intégré selon l'une des revendications 3 et 4, **caractérisé en ce que** le circuit d'ajustement de la tension de sur-polarisation inverse de grille comporte deux entrées reliées aux sorties (UP, DN) du comparateur de courant (CMP), et un ensemble de deux transistors (Q1, Q2) montés en série en push-pull analogique, les grilles de ces transistors étant commandées l'une à partir d'une des entrées l'autre à partir de l'autre entrée, la sortie du circuit d'ajustement étant constituée par les drains réunis des deux transistors (Q1, Q2).

## Claims

1. Method for controlling the leakage current of a power transistor (TP) inserted in series between a supply terminal (A) and an active circuit (CA), in which the power transistor is strongly turned off in standby mode by a gate reverse overbias, **characterized in that** it comprises the following operations:
- biasing a first reference transistor (MA), and a second reference transistor (MB) identical to the first and of technological characteristics representative of the power transistor, with the same gate reverse overbias voltage (Vg) as the power transistor, the first transistor having its source linked to the supply terminal (A), and the second reference transistor having its source linked to its drain,
- comparing the currents flowing through the two reference transistors (MA, MB) in a current comparator (CMP),
- modifying the gate reverse overbias voltage (Vg) in a direction that tends to reduce the difference between the compared currents.

2. Integrated circuit comprising a power transistor (TP) in series between a supply terminal (A) and an active circuit (CA) capable of operating in active mode or in standby mode, and a gate bias circuit (CGM) for applying to the gate of the power transistor a forward bias potential in active mode to turn on the transistor and a reverse overbias potential Vg in standby mode to strongly turn off the transistor, **characterized in that** the bias circuit comprises
- a first reference transistor (MA) and a second reference transistor (MB), identical to one another and of technological characteristics representative of the power transistor (TP), receiving on their gate in standby mode the same reverse bias voltage Vg as the power transistor, the first reference transistor (MA) having its source linked to the same potential as the source of the power transistor, and the second reference transistor (MB) having its source and its drain joined,
- a circuit (CMP) for comparing the leakage currents of the first and second transistors, this comparison circuit having an input (InA) linked to the drain of the first reference transistor (MA) and an input (InB) linked to the drain of the second reference transistor (MB),
- and a circuit (CVg) for adjusting the reverse overbias voltage Vg, receiving the output of the comparison circuit and reacting to this output so as to increase or decrease the reverse overbias voltage Vg according to the sense of the result of the comparison performed by the comparison circuit so as to reduce the difference between the leakage currents of the first and second transistors.

3. Integrated circuit according to Claim 2, **characterized in that** the circuit for comparing currents comprises a circuit (Ta2, Ta3, Ta4, Tb2, Tb3, Tb4) producing a brief pulse on a first output (UP) if the current on a first input is higher than on the second, and a brief pulse on a second output (DN) if the current on the second input is higher than on the first.

4. Integrated circuit according to Claim 3, **characterized in that** the circuit for comparing currents comprises two differential branches (Ta3, Ta2, Ta4; Tb3, Tb2, Tb4) retroacting on one another so as to produce fast toggling in the event of a difference in currents on the inputs, and a precharge circuit establishing a signal for triggering a comparison (PRE) whose startup is controlled by a clock edge and whose stopping is controlled by the appearance of a brief pulse on one of the outputs of the comparator.

5. Integrated circuit according to one of Claims 2 to 4, **characterized in that** the inputs of the circuit for comparing currents are each linked to a current-voltage converter (Ta1, Tb1).

6. Integrated circuit according to Claim 5, **characterized in that** the voltage converter is a transistor mounted as diode (Ta1, Tb1) between the input and another supply terminal (M).

7. Integrated circuit according to either of Claims 3 and 4, **characterized in that** the circuit for adjusting the gate reverse overbias voltage comprises two inputs linked to the outputs (UP, DN) of the current comparator (CMP), and a set of two transistors (Q1, Q2) mounted in series in analog push-pull arrangement, the gates of these transistors being controlled the one on the basis of one of the inputs the other on the basis of the other input, the output of the adjustment circuit being constituted by the joined drains of the two transistors (Q1, Q2).

## Patentansprüche

1. Verfahren zur Überwachung des Leckstroms eines Leistungstransistors (TP), der in Reihe zwischen eine Anschlussklemme (A) und eine aktive Schaltung (CA) eingefügt ist, bei dem der Leistungstransistor im Standby-Modus von einer Gate-Übervorspannung in Sperrrichtung stark blockiert wird, **dadurch gekennzeichnet, dass** es die folgenden Vorgänge enthält:
- Vorspannen eines ersten Referenztransistors (MA) und eines zweiten Referenztransistors (MB) gleich dem ersten und mit für den Leistungstransistor repräsentativen technologischen Eigenschaften, mit der gleichen Gate-Übervorspannung in Sperrrichtung (Vg) wie der Leistungstransistor, wobei die Source des ersten Transistors mit der Anschlussklemme (A) und die Source des zweiten Referenztransistors mit seinem Drain verbunden ist,
- Vergleich der durch die zwei Referenztransistoren (MA, MB) fließenden Ströme in einem Stromkomparator (CMP),
- Ändern der Gate-Übervorspannung in Sperrrichtung (Vg) in einer Richtung, die dahin tendiert, die Differenz zwischen den verglichenen Strömen zu reduzieren.

2. Integrierte Schaltung, die einen Leistungstransistor (TP) in Reihe zwischen einer Anschlussklemme (A) und einer aktiven Schaltung (CA), die im aktiven oder im Standby-Modus arbeiten kann, und eine Gate-Vorspannungsschaltung (CGM) aufweist, um an das Gate des Leistungstransistors ein Durchlassvorspannungs-Potential im aktiven Modus anzulegen, um den Transistor leitend zu machen, und ein Übervorspannungspotential in Sperrrichtung Vg im Standby-Modus anzulegen, um den Transistor stark zu blockieren, **dadurch gekennzeichnet, dass** die Vorspannungsschaltung aufweist
- einen ersten Referenztransistor (MA) und einen zweiten Referenztransistor (MB), die einander gleich sind und für den Leistungstransistor (TP) repräsentative technologische Eigenschaften haben, an ihrem Gate im Standby-Modus die gleiche Vorspannung in Sperrrichtung Vg wie der Leistungstransistor empfangen, wobei die Source des ersten Referenztransistors (MA) mit dem gleichen Potential verbunden ist wie die Source des Leistungstransistors, und die Source des zweiten Referenztransistors (MB) mit seinem Drain vereint ist,
- eine Vergleichsschaltung (CMP) der Leckströme des ersten und des zweiten Transistors, wobei diese Vergleichsschaltung einen Eingang (InA), der mit dem Drain des ersten Referenztransistors (MA) verbunden ist, und einen Eingang (InB) hat, der mit dem Drain des zweiten Referenztransistors (MB) verbunden ist,
- und eine Schaltung (CVg) zur Anpassung der Übervorspannung in Sperrrichtung Vg, die das Ausgangssignal der Vergleichsschaltung empfängt und auf dieses Ausgangssignal reagiert, um die Übervorspannung in Sperrrichtung Vg je nach der Richtung des Ergebnisses des von der Vergleichsschaltung durchgeführten Vergleichs zu erhöhen oder zu senken, um die Differenz zwischen den Leckströmen des ersten und des zweiten Transistors zu reduzieren.

3. Integrierte Schaltung nach Anspruch 2, **dadurch gekennzeichnet, dass** die Stromvergleichsschaltung eine Schaltung (Ta2, Ta3, Ta4, Tb2, Tb3, Tb4) aufweist, die einen kurzen Impuls an einem ersten Ausgang (UP) erzeugt, wenn der Strom an einem ersten Eingang höher ist als am zweiten Eingang, und einen kurzen Impuls an einem zweiten Ausgang (DN) erzeugt, wenn der Strom am zweiten Eingang höher ist als am ersten Eingang.

4. Integrierte Schaltung nach Anspruch 3, **dadurch gekennzeichnet, dass** die Stromvergleichsschaltung zwei differentielle Zweige (Ta3, Ta2, Ta4; Tb3, Tb2, Tb4), die aufeinander rückwirken, um ein schnelles Umschalten im Fall einer Stromdifferenz an den Eingängen zu erzeugen, und eine Vorladeschaltung aufweist, die ein Auslösesignal eines Vergleichs (PRE) erzeugt, dessen Start von einer Taktsignalflanke gesteuert wird und dessen Unterbrechung vom Auftreten eines kurzen Impulses an einem der Ausgänge des Komparators gesteuert wird.

5. Integrierte Schaltung nach einem der Ansprüche 2 bis 4, **dadurch gekennzeichnet, dass** die Eingänge der Stromvergleichsschaltung je mit einem Strom/SpannungsWandler (Ta1, Tb1) verbunden sind.

6. Integrierte Schaltung nach Anspruch 5, **dadurch gekennzeichnet, dass** der Spannungswandler ein zwischen den Eingang und eine andere Anschlussklemme (M) als Diode (Ta1, Tb1) geschalteter Transistor ist.

7. Integrierte Schaltung nach einem der Ansprüche 3 und 4, **dadurch gekennzeichnet, dass** die Anpassungsschaltung der Gate-Übervorspannung in Sperrrichtung zwei Eingänge, die mit den Ausgängen (UP, DN) des Stromkomparators (CMP) verbunden sind, und eine Einheit von zwei Transistoren (Q1, Q2) aufweist, die in analogem Gegentakt in Reihe geschaltet sind, wobei die Gates dieser Transistoren das eine ausgehend von einem der Eingänge und das andere ausgehend von dem anderen Eingang gesteuert werden, wobei der Ausgang der Anpassungsschaltung aus den vereinten Drains der zwei Transistoren (Q1, Q2) besteht.
